(19) Europäisches Patentamt
European Patent Office
Office européen des brevets

(11) **EP 3 836 338 A1**

(12) **DEMANDE DE BREVET EUROPEEN**

(43) Date de publication:
**16.06.2021 Bulletin 2021/24**

(51) Int Cl.:
*H02J 3/38* (2006.01)        *H02J 3/46* (2006.01)
*F02D 29/06* (2006.01)

(21) Numéro de dépôt: **20213001.9**

(22) Date de dépôt: **10.12.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(30) Priorité: **13.12.2019 FR 1914387**

(71) Demandeur: **Commissariat à l'Energie Atomique et aux Energies Alternatives**
**75015 Paris (FR)**

(72) Inventeur: **HA, Duy Long**
**38054 GRENOBLE CEDEX 09 (FR)**

(74) Mandataire: **Cabinet Camus Lebkiri**
**25 rue de Maubeuge**
**75009 Paris (FR)**

(54) **PROCÉDÉ DE DÉTERMINATION DE CARACTÉRISTIQUES INDIVIDUELLES DE CONSOMMATION EN CARBURANT DE DIFFÉRENTS GROUPES ÉLECTROGÈNES D'UN ENSEMBLE DE PRODUCTION**

(57) L'invention concerne un procédé de détermination de caractéristiques individuelles de consommation en carburant ($SFC_1$, $SFC_i$, $SFC_n$) de différents groupes électrogènes ($G_1$, $G_i$, $G_n$) d'un ensemble de production (10) d'électricité.

Ce procédé comprend :

a) une acquisition de données d'exploitation rassemblant, pour plusieurs instants d'acquisition, une mesure d'un débit total de carburant ($D_{mes,k}$) consommé par l'ensemble de production, et des mesures des taux de charge respectifs ($LR_{mes,k,i}$) des différents groupes électrogènes, et

b) une détermination des caractéristiques individuelles de consommation en carburant de ces différents groupes électrogènes, à partir de ces données d'exploitation acquises.

L'invention concerne aussi un dispositif (20) associé de surveillance d'un tel ensemble de production d'électricité, un procédé de pilotage d'un tel ensemble, et un procédé de détection d'un besoin de maintenance d'un groupe électrogène d'un tel ensemble de production.

**Fig. 1**

**Description**

**DOMAINE TECHNIQUE DE L'INVENTION**

Le domaine technique de l'invention est celui de la production d'électricité au moyen de groupes électrogènes.
L'invention concerne plus précisément le suivi, la surveillance et le pilotage d'un ensemble de production d'électricité comprenant plusieurs groupes électrogènes.

**ARRIERE-PLAN TECHNOLOGIQUE DE L'INVENTION**

Dans de nombreux contextes, la production d'électricité est assurée non pas par une centrale électrique alimentant toute une région, mais, de manière plus locale, par un ensemble de production d'électricité de plus petite capacité, parfois appelé « micro-réseau ».
C'est le cas par exemple pour des villages isolés dans lesquels la production d'électricité est assurée par un ensemble de groupes électrogènes.
Les navires de fort tonnage, en particulier les navires de croisière accueillant de nombreux passagers sont bien souvent équipés eux aussi d'un ensemble de production d'électricité comprenant plusieurs groupes électrogènes, qui alimentent le navire en électricité. L'ensemble de production d'électricité est alors piloté de manière à fournir une puissance électrique totale suffisante pour alimenter les différentes installations du navire. Pour cela, le nombre de groupes électrogènes en fonctionnement, et le régime de fonctionnement de chaque groupe électrogène sont ajustés en fonction de la puissance électrique totale demandée.
La manière de répartir la puissance électrique totale à produire, entre les différents groupes électrogènes de l'ensemble de production, peut avoir une influence importante sur la consommation totale en carburant de cet ensemble de production. En effet, le rendement d'un groupe électrogène dépend de son point de fonctionnement et il est bien sûr préférable de répartir la puissance électrique totale à produire de manière à ce que les groupes électrogènes en fonctionnement fonctionnent chacun près de leur point de fonctionnement optimal. Et, même pour leur meilleur point de fonctionnement, tous les groupes électrogènes de l'ensemble n'ont pas nécessairement le même rendement, si bien qu'il peut être intéressant d'utiliser en priorité certains groupes électrogènes de l'ensemble de production plutôt que d'autres, lorsque la puissance électrique totale à produire reste réduite.
Pour pouvoir piloter au mieux l'ensemble de production d'électricité, afin de réduire sa consommation totale en carburant, il est donc souhaitable de connaitre le rendement de chaque groupe électrogène de l'ensemble de production (ou tout autre quantité renseignant sur la consommation en carburant de ce groupe), ainsi que la façon dont ce rendement varie en fonction du point de fonctionnement du groupe électrogène (pour en tenir compte lors du pilotage de l'ensemble de production d'électricité).
Le rendement d'un groupe électrogène est généralement caractérisé par sa consommation spécifique en carburant (ou SFC en anglais, pour « Specific Fuel Consumption »), c'est-à-dire par la masse de carburant consommée pour produire une énergie électrique donnée. Sa consommation spécifique en carburant peut ainsi s'exprimer en gramme par kilowattheure (g/kWh) par exemple. Plus le rendement du groupe électrogène est élevé et plus sa consommation spécifique en carburant est basse. Quant au point de fonctionnement du groupe électrogène, il est généralement caractérisé par un taux de charge du groupe électrogène, égal à la puissance électrique produite par le groupe électrogène à un instant donné, divisée par sa puissance nominale maximale.
La plupart des constructeurs et fournisseurs de groupes électrogènes fournissent des valeurs de consommation spécifique en carburant pour les différents modèles de groupes électrogènes qu'ils distribuent, et cela pour quelques valeurs de taux de charge.
Mais ces valeurs de consommation spécifique ne sont généralement indiquées que pour trois ou quatre valeurs différentes du taux de charge du groupe électrogène. Et ces valeurs ne tiennent pas compte d'un éventuel vieillissement du groupe électrogène depuis son installation, et des éventuelles variations intrinsèques des caractéristiques des groupes au sein d'une même série.
Pour obtenir des données de consommation spécifique plus précises, ou plus complètes, on pourrait réaliser des essais, pour chaque groupe électrogène de l'ensemble de production. Mais cela impliquerait, idéalement à intervalle régulier, une mise en arrêt au moins partielle de l'ensemble de production d'électricité, et des modifications de celui-ci (une déconnexion du groupe à tester, ou l'installation d'un débitmètre de carburant individuel juste en amont de celui-ci), le temps de réaliser les essais.
Dans ce contexte, il serait donc souhaitable de pouvoir déterminer les consommations spécifiques en carburant des différents groupes électrogènes d'un tel ensemble de production d'électricité, en situation, c'est-à-dire autant que possible sans modification ou arrêt de l'ensemble de production d'électricité.

**EP 3 836 338 A1**

**RESUME DE L'INVENTION**

Pour résoudre au moins en partie les problèmes mentionnés ci-dessus, l'invention propose de déterminer des caractéristiques individuelles de consommation en carburant de différents groupes électrogènes d'un ensemble de production d'électricité,

- les caractéristiques individuelles de consommation associées à chaque groupe électrogène étant représentatives de la consommation spécifique en carburant du groupe électrogène considéré, pour différents taux de charge du groupe électrogène,

- les différents groupes électrogènes dudit ensemble de production étant alimentés en carburant par une même source de carburant munie d'un moyen de mesure qui délivre une mesure d'un débit total de carburant consommé par l'ensemble des groupes électrogènes dudit ensemble de production,

- chaque groupe électrogène étant muni d'un capteur qui délivre une mesure d'un taux de charge du groupe électrogène considéré,

- le procédé comprenant les étapes suivantes :

  - a) acquérir des données d'exploitation qui, pour différents instants d'acquisition ($t_k$) répartis au cours d'une période d'acquisition donnée, regroupent : la mesure du débit total de carburant consommé, à l'instant d'acquisition considéré, et, pour chaque groupe électrogène de l'ensemble de production, la mesure du taux de charge du groupe électrogène considéré, à l'instant d'acquisition considéré, et
  - b) déterminer les caractéristiques individuelles de consommation des différents groupes électrogènes de l'ensemble de production, par une procédure de minimisation d'un écart cumulé qui tient compte d'un ensemble d'écarts instantanés associés respectivement aux différents instants d'acquisition, chaque écart instantané étant un écart, pour l'instant d'acquisition considéré, entre : d'une part, la mesure du débit total de carburant, et d'autre part, une estimation du débit total de carburant consommé par ledit ensemble de production d'électricité, ladite estimation du débit total étant égale à la somme de débits individuels estimés, associés respectivement aux différents groupes électrogènes de l'ensemble de production, chaque débit individuel estimé étant déterminé sur la base :

    - de la mesure du taux de charge du groupe électrogène considéré, à l'instant d'acquisition considéré, et

    - des caractéristiques individuelles de consommation en carburant du groupe électrogène considéré,

      - ladite période d'acquisition comprenant plusieurs périodes d'exploitations distinctes, une puissance électrique totale produite par l'ensemble de production étant répartie de manières différentes entre les groupes électrogènes de l'ensemble de production au cours des différentes périodes d'exploitation.

Ce procédé permet avantageusement de déterminer les caractéristiques *individuelles* de consommation en carburant des différents groupes électrogènes de l'ensemble de production, sur la base des données d'exploitation mentionnées plus haut, qui peuvent être obtenues lors du fonctionnement usuel de l'ensemble de production (donc sans nécessiter d'interruption de ce fonctionnement usuel), et cela alors que l'ensemble de production d'électricité est pourvu d'un seul moyen de mesure d'un débit en carburant (d'un seul débitmètre).

Les inventeurs ont constaté que les caractéristiques individuelles de consommation des groupes électrogènes, déterminées conformément à ce procédé, permettent de rendre compte précisément du débit total de carburant consommé par l'ensemble de production.

A titre d'exemple, pour un ensemble de production comportant 3 groupes électrogènes, l'écart cumulé obtenu (écart entre le débit total mesuré et l'estimation de ce débit), pour une période d'acquisition de 19 jours, est inférieur à 0,1% environ une fois cet écart minimisé en ajustant les caractéristiques individuelles en question. Et, au cours de cette même période d'acquisition, pour des durées courtes, inférieure à 2 heures environ, un écart moyen inférieur à 1% a été obtenu (les caractéristiques individuelles en question restant égales à celles obtenues en minimisant l'écart cumulé global en question).

Et, une fois que ces caractéristiques individuelles ont été déterminées et fixées, il s'avère que l'écart cumulé entre la mesure du débit total, et l'estimation de ce débit, reste inférieur à 2% environ pour une période, ultérieure, de 19 jours environ (alors que les caractéristiques individuelles en question conservent alors des valeurs fixes). Les caractéristiques individuelles de consommation, déterminées conformément à ce procédé, ont donc en quelque sorte une valeur prédictive, et sont donc bien appropriées pour servir ensuite de base au pilotage de l'ensemble de production d'électricité, ou pour servir de base à la détection d'un besoin de maintenance de l'un des groupes électrogènes.

Pouvoir déterminer des caractéristiques *individuelles* de consommation en carburant précises, fiables, avec un seul débitmètre global est particulièrement intéressant car un tel débitmètre est onéreux, nettement plus que les capteurs qui équipent les différents groupes électrogènes afin de mesurer leurs taux de charge respectifs (capteurs qui peuvent être réalisés sous la forme de compteurs électriques). En outre, de nombreux ensembles de production d'électricité déjà installés et en service sont pourvus seulement d'un débitmètre global. Equiper alors chaque groupe électrogène de cet ensemble avec un débitmètre individuel impliquerait donc un arrêt et des modifications de cet ensemble de production.

Le fait que l'on puisse ainsi déterminer des caractéristiques *individuelles* de consommation en carburant précises, fiables, avec un seul débitmètre global s'explique notamment par le fait que la puissance électrique totale, produite par l'ensemble de production, est répartie de différentes manières entre les groupes électrogènes de l'ensemble de production, au cours de la période d'acquisition en question (qui comporte plusieurs périodes d'exploitation distinctes).

A titre d'exemple, pour un ensemble de production d'électricité comprenant trois groupes électrogènes différents, la période d'acquisition pourrait comprendre trois périodes d'exploitation distinctes, au cours desquelles un premier, un deuxième, puis respectivement un troisième de ces groupes électrogènes est éteint tandis que les deux autres produisent la puissance électrique à fournir. Ce type de fonctionnement, avec une alternance entre groupes électrogènes, favorise une détermination précise des caractéristiques *individuelles* de consommation des différentes groupes électrogènes de l'ensemble de production. Les variations de besoin de puissance totale durant les périodes d'exploitation fournissent un autre élément de détermination pour les groupes en fonctionnement.

Et en l'occurrence, c'est ce type de pilotage, avec une alternance entre groupes électrogènes, qui est généralement employé lors du fonctionnement d'un tel ensemble de production d'électricité. En effet, par précaution, l'ensemble de production d'électricité comprend généralement au moins un groupe électrogène de plus que le nombre de groupes électrogènes qui serait juste suffisant pour produire la puissance électrique totale maximale pour laquelle l'ensemble de production est prévu. Le plus souvent, il n'est donc pas nécessaire de faire fonctionner tous les groupes électrogènes en même temps, l'un d'eux (voire plus) restant éteint. Et l'on pilote les différents groupes électrogènes de manière à les éteindre à tour de rôle (ou tout au moins de manière à les faire fonctionner à bas régime à tour de rôle), pour obtenir une usure homogène et une meilleure gestion de la maintenance entre les différents groupes électrogènes.

Le procédé de détermination décrit ci-dessus peut donc être mis en œuvre sur la base de données d'exploitation acquises lors d'un fonctionnement habituel de l'ensemble de production. Autrement formulé, en général, l'acquisition de ces données d'exploitation ne nécessite pas de piloter l'ensemble de production d'une manière différente de son pilotage usuel, si bien que ce procédé de détermination peut être mis en œuvre sans perturber le fonctionnement habituel de cet ensemble de production.

Le fait de pouvoir déterminer précisément les caractéristiques individuelles de consommation des différents groupes électrogène d'un tel ensemble de production représente un enjeu particulièrement important en pratique, notamment pour les navires de croisière de fort tonnage à bord desquels la consommation totale d'électricité est très importante. En effet, l'optimisation du pilotage des groupes électrogènes d'un tel navire, qui nécessite une bonne connaissance de leurs caractéristiques individuelles, permet alors une réduction substantielle de la consommation en carburant du navire.

Une fois déterminées, ces caractéristiques individuelles permettent en outre de détecter que l'un des groupes électrogènes a un fonctionnement qui s'écarte d'un fonctionnement de référence considéré comme normal, et qu'il nécessite donc une intervention de maintenance. Pouvoir détecter ainsi qu'un ou plusieurs des groupes électrogènes nécessite une opération de maintenance, sur la base des données d'exploitation acquises lors du fonctionnement usuel de l'ensemble de production, est particulièrement intéressant dans le cas déjà mentionné d'un navire de fort tonnage. En effet, les escales d'un tel navire, aux cours desquelles les opérations de maintenance peuvent être réalisées, sont généralement courtes par rapport à la durée passée en mer par le navire. Il est donc particulièrement intéressant de pouvoir déterminer, avant qu'une escale n'ait lieu, si un ou plusieurs des groupes électrogènes du navire nécessite une maintenance.

Pour chaque groupe électrogène de l'ensemble de production d'électricité, les caractéristiques individuelles de consommation mentionnées ci-dessus caractérisent la consommation spécifique en carburant de ce groupe électrogène, sur un intervalle de taux de charge qui s'étend au moins de 50 % à 70 %.

Les caractéristiques individuelles de consommation peuvent par exemple être directement égales à des valeurs de consommation spécifique en carburant du groupe électrogène Gi considéré, pour plusieurs taux de charge de ce groupe électrogène (répartis sur intervalle de taux de charge qui s'étend au moins de 50 % à 70 %, préférentiellement de 10% à 80% au moins). Pour chaque groupe électrogène, les caractéristiques individuelles en question regroupent alors plusieurs couples de valeurs $(LR_j, SFC_{i,j})$, chaque couple rassemblant une valeur de taux de charge $LR_j$, (ou « Load Rate », en anglais) et une valeur correspondante de consommation spécifique en carburant $SFC_{i,j}$ qui est égale à la consommation spécifique en carburant du groupe électrogène Gi lorsque ce groupe électrogène fonctionne avec un taux de charge ayant cette valeur LR$_j$.

Mais les caractéristiques individuelles de consommation pourraient aussi être égales à toute autre grandeur représentative de la consommation spécifique en carburant du groupe électrogène considéré. A titre d'exemple, ces caractéristiques individuelles de consommation pourraient être égales à des valeurs d'un rendement énergétique du groupe électrogène considéré, associées respectivement à différents taux de charge de ce groupe électrogène (le rendement en question étant inversement proportionnel à la consommation spécifique en carburant du groupe électrogène).

Par ailleurs, pour caractériser la consommation spécifique en carburant du groupe électrogène pour différents taux de charge, les caractéristiques individuelles de consommation pourraient regrouper plusieurs valeurs de consommation spécifique en carburant, ou de rendement, associées respectivement à différentes valeurs d'une grandeur représentative du taux de charge du groupe électrogène, cette grandeur pouvant être différente du taux de charge en question. A titre d'exemple, cette grandeur pourrait correspondre à la puissance électrique instantanée produite par le groupe électrogène en question, plutôt qu'à son taux de charge.

Quant aux mesures des taux de charge des différents groupes électrogènes, acquises à l'étape a), elles sont représentatives de ces différents taux de charge, à l'instant considéré. Ces mesures peuvent, là aussi, être directement égales aux valeurs de ces taux charge. Mais ces mesures pourraient aussi être égales aux valeurs des puissance électriques produites, à l'instant considéré, par les différents groupes électrogènes de l'ensemble de production d'électricité, par exemple.

Au cours du procédé de détermination qui vient d'être présenté, les caractéristiques individuelles de consommation des différents groupes électrogènes de l'ensemble de production peuvent être déterminées, au cours de la procédure de minimisation de l'étape b), de manière à respecter la contrainte suivante : pour chaque groupe électrogène, la consommation spécifique en carburant du groupe électrogène est décroissante en fonction du taux de charge de ce groupe électrogène, sur au moins un intervalle qui s'étend d'un premier seuil de taux de charge jusqu'à un deuxième seuil de taux de charge.

Prendre en compte cette contrainte permet de tenir compte du fait que le rendement d'un groupe électrogène augmente généralement avec son taux de charge jusqu'à atteindre un maximum correspondant au point de fonctionnement optimal du groupe électrogène. Par exemple, si ce point de fonctionnement optimal correspond à un taux de charge de 85%, le rendement du groupe électrogène augmente généralement sur toute la plage de taux de charge qui s'étend de 0% jusqu'à 85% (ce rendement diminuant ensuite). Autrement formulé, la consommation spécifique en carburant de ce groupe électrogène diminue alors sur toute la plage de taux de charge qui s'étend de 0% jusqu'à 85% (cette consommation spécifique augmentant ensuite).

On peut d'ailleurs prévoir que les premier et deuxième seuils de taux de charge, qui interviennent dans le procédé de détermination, soient choisis en fonction du type de groupe électrogène employé. Par exemple, si le constructeur de ces groupes électrogènes indique que le point de fonctionnement optimal ces groupes électrogènes correspond à un taux de charge compris entre 80 et 90%, le premier seuil de taux de charge pourra être ajusté à une valeur comprise entre 0 et 10% tandis que le deuxième seuil de taux de charge sera ajusté à une valeur comprise entre 80% et 90%, par exemple égale à 80%.

Tenir compte de cette caractéristique physique propre au fonctionnement de la plupart des groupes électrogènes (i.e. : tenir compte de l'augmentation du rendement lorsque le taux de charge augmente), lors de la procédure de minimisation en question, permet de réduire l'espace de travail dans lequel une solution minimisant l'écart cumulé est recherchée. Cela permet de diminuer le temps de calcul nécessaire pour obtenir cette solution, c'est-à-dire pour déterminer les caractéristiques individuelles de consommation qui minimisent l'écart cumulé mentionné plus haut.

En outre, cela permet d'écarter directement des solutions (c'est-à-dire des jeux de caractéristiques individuelles de consommation de carburant) qui minimiseraient l'écart cumulé en question mais qui seraient incorrectes physiquement, non représentatives de la consommation spécifique réelle des groupes électrogènes.

Pour illustrer ce point, considérons par exemple les consommations spécifiques en carburant réelles, effectives, des différents groupes électrogènes d'un ensemble de production comprenant trois groupes électrogènes. Pour ces valeurs de consommation spécifique, la valeur de l'écart cumulé est minimale.

Mais une valeur aussi basse peut être obtenue pour l'écart cumulé avec un jeu de consommations spécifiques qui comprendrait :

- pour le premier groupe électrogène, la consommation spécifique réelle de de ce groupe électrogène, à laquelle serait ajoutée une fonction qui oscille rapidement en fonction du taux de charge,

- pour le deuxième groupe électrogène, la consommation spécifique réelle de ce groupe électrogène, à laquelle serait soustraite la fonction oscillante en question, et

- pour le troisième groupe électrogène, la consommation spécifique réelle de ce groupe électrogène.

Cette dernière solution (avec une oscillation de la consommation spécifique pour les deux premiers groupes électrogènes) n'est pas acceptable, alors qu'elle minimise également l'écart cumulé en question.

Pour éviter d'aboutir à une telle solution lors de l'exécution de l'étape b) (ce qui obligerait alors à exécuter à nouveau cette étape jusqu'à trouver une solution acceptable physiquement), il est donc intéressant de prendre en compte la contrainte physique mentionnée plus haut, lors de la procédure de minimisation de l'écart cumulé.

Outre les caractéristiques présentées ci-dessus, le procédé de détermination peut présenter une ou plusieurs des caractéristiques optionnelles suivantes, considérées individuellement ou selon toutes les combinaisons techniquement possibles :

- le premier seuil de taux de charge est inférieur ou égal à 10%, et le deuxième seuil de taux de charge est compris entre 70% et 95% ;

- l'écart cumulé est égal ou proportionnel à la somme desdits écarts instantanés ;

- chaque débit individuel estimé est déterminé en :

    - déterminant une consommation spécifique en carburant correspondant à la mesure du taux de charge du groupe électrogène considéré à l'instant d'acquisition considéré, par interpolation, à partir des caractéristiques individuelles de consommation du groupe électrogène considéré, puis en

    - multipliant ladite consommation spécifique en carburant par ladite mesure du taux de charge et par une puissance nominale maximale du groupe électrogène considéré ;

- la période d'acquisition comprend au moins autant de périodes d'exploitation différentes que de groupes électrogènes ;

- ladite période d'acquisition dure une journée au moins ;

- ladite période d'acquisition dure plusieurs jours et au moins certaines desdites périodes d'exploitation durent chacune une journée ou plus ;

- pour chaque groupe électrogène dudit ensemble de production d'électricité:

    - au cours de l'une au moins desdites périodes d'exploitation, le groupe électrogène considéré fonctionne avec un taux de charge inférieur à 50%, et

    - au cours d'une autre desdites périodes d'exploitation, le groupe électrogène considéré fonctionne avec un taux de charge supérieur à 70%.

L'invention concerne aussi un procédé de pilotage d'un ensemble de production d'électricité qui comporte plusieurs groupes électrogènes, le procédé comprenant :

- une détermination de caractéristiques individuelles de consommation en carburant, pour les différents groupes électrogènes de l'ensemble de production d'électricité, ladite détermination étant réalisée conformément au procédé de détermination présenté ci-dessus, et

- un pilotage desdits groupes électrogènes, de manière à qu'ils fonctionnent avec des taux de charges respectifs déterminés sur la base des caractéristiques individuelles de consommation en carburant précédemment déterminées.

L'invention concerne également un procédé de détection d'un besoin de maintenance d'un ou plusieurs groupes électrogènes d'un ensemble de production d'électricité comportant plusieurs groupes électrogènes, le procédé comprenant :

- 1) une détermination de caractéristiques individuelles de consommation en carburant, pour les différents groupes électrogènes de l'ensemble de production d'électricité, ladite détermination étant réalisée conformément au procédé de détermination qui a été présenté plus haut, et

- 2) une identification, parmi lesdits groupes électrogènes, d'un ou plusieurs groupes électrogènes pour lesquels une différence, entre les caractéristiques individuelles de consommation (du groupe électrogène considéré, déterminées à l'étape 1) et des caractéristiques individuelles de référence, est supérieure à un seuil donné, ledit ou lesdits groupes électrogènes étant alors identifiés comme nécessitant une maintenance.

On peut prévoir que les caractéristiques individuelles de référence mentionnées ci-dessus soient égales, pour chaque groupe électrogène, à :

- une moyenne des caractéristiques individuelles de consommation ayant été déterminées, à l'étape 1), pour les autres groupes électrogènes dudit ensemble de production d'électricité, ou à

- une moyenne des caractéristiques individuelles de consommation ayant été déterminées, à l'étape 1), pour l'ensemble des groupes électrogènes dudit ensemble de production d'électricité, ou à

- des caractéristiques individuelles de consommation du groupe électrogène considéré fournies par un constructeur du groupe électrogène, ou à

- des caractéristiques individuelles de consommation du groupe électrogène considéré, qui ont été déterminées juste après avoir installé ce groupe électrogène ou juste après une opération de maintenance de ce groupe électrogène ou lors d'une période temporelle antérieure non-séparée de ladite période d'acquisition par une opération de maintenance, et qui ont été enregistrées pour servir ensuite de caractéristiques individuelles de consommation de référence pour ce groupe électrogène.

L'invention concerne également un dispositif de surveillance d'un ensemble de production d'électricité,

- l'ensemble de production comportant plusieurs groupes électrogènes étant alimentés en carburant par une même source de carburant munie d'un moyen de mesure qui délivre une mesure d'un débit total de carburant consommé par l'ensemble des groupes électrogènes dudit ensemble de production, chaque groupe électrogène étant muni d'un capteur qui délivre une mesure d'un taux de charge du groupe électrogène considéré,

- le dispositif de surveillance comprenant au moins un module d'acquisition, une mémoire et un module de calcul comprenant un processeur, le dispositif de surveillance étant programmé pour déterminer des caractéristiques individuelles de consommation en carburant des différents groupes électrogènes de l'ensemble de production, les caractéristiques individuelles de consommation, associées à chaque groupe électrogène étant représentatives de la consommation spécifique en carburant du groupe électrogène considéré, pour différents taux de charge du groupe électrogène,

- le dispositif de surveillance étant programmé pour déterminer lesdites caractéristiques individuelles en exécutant les étapes suivantes :

- a) acquérir, au moyen du module d'acquisition, des données d'exploitation qui, pour différents instants d'acquisition ($t_k$) répartis au cours d'une période d'acquisition donnée, regroupent: la mesure du débit total de carburant consommé, à l'instant d'acquisition considéré, et, pour chaque groupe électrogène de l'ensemble de production, la mesure du taux de charge du groupe électrogène considéré, à l'instant d'acquisition considéré, et

- b) déterminer, au moyen du module de calcul, les caractéristiques individuelles de consommation des différents groupes électrogènes de l'ensemble de production, par une procédure de minimisation d'un écart cumulé qui tient compte d'un ensemble d'écarts instantanés associés respectivement aux différents instants d'acquisition, chaque écart instantané étant un écart, pour l'instant d'acquisition considéré, entre : d'une part, la mesure du débit total de carburant, et, d'autre part, une estimation du débit total de carburant consommé par ledit ensemble de production d'électricité, ladite estimation du débit total étant égale à la somme de débits individuels estimés, associés respectivement aux différents groupes électrogènes de l'ensemble de production, chaque débit individuel estimé étant déterminé sur la base :

- de la mesure du taux de charge du groupe électrogène considéré, à l'instant d'acquisition considéré, et

- des caractéristiques individuelles de consommation en carburant du groupe électrogène considéré,

- ladite période d'acquisition comprenant plusieurs périodes d'exploitations distinctes, une puissance

7

électrique totale produite par l'ensemble de production étant répartie de manières différentes entre les groupes électrogènes de l'ensemble de production au cours des différentes périodes d'exploitation.

Les caractéristiques optionnelles, présentées plus haut en termes de procédé, peuvent aussi s'appliquer au dispositif de surveillance qui vient d'être décrit.

L'invention sera mieux comprise à la lecture de la description qui suit et à l'examen des figures qui l'accompagnent.

## BREVE DESCRIPTION DES FIGURES

Les figures sont présentées à titre indicatif et nullement limitatif de l'invention.

[Fig. 1] La figure 1 représente schématiquement un ensemble de production d'électricité comprenant plusieurs groupes électrogènes.

[Fig. 2] La figure 2 représente schématiquement les principales étapes d'un procédé de détermination de caractéristiques individuelles de consommation en carburant des différents groupes électrogènes de l'ensemble de production de la figure 1.

[Fig. 3] La figure 3 montre des courbes de consommations spécifiques en carburant, caractéristiques individuelles de consommation en question, pour les différents groupes électrogènes de l'ensemble de production de la figure 1.

[Fig. 4] La figure 4 représente schématiquement des étapes d'un procédé de détection d'un besoin de maintenance d'un groupe électrogène d'un ensemble de production d'électricité tel que celui de la figure 1.

## DESCRIPTION DETAILLEE

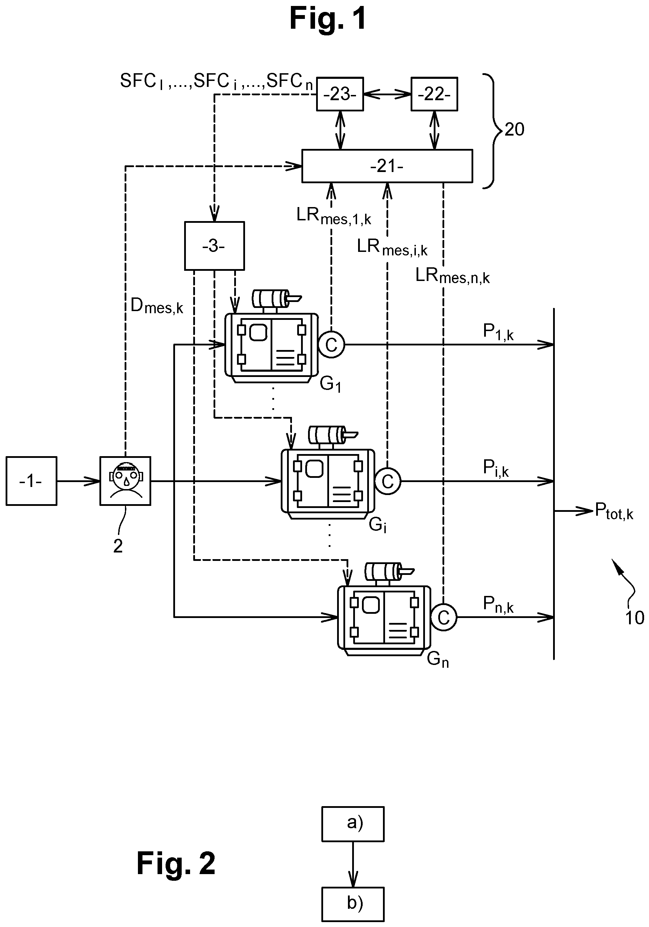

La figure 1 représente schématiquement un ensemble de production d'électricité 10 comprenant plusieurs groupes électrogènes $G_1,..., G_i,... , G_n$. L'ensemble de production d'électricité comprend en tout n groupes électrogènes. Chaque groupe électrogène est repéré par un indice i entier, compris entre 1 et n.

Par groupe électrogène on entend ici un dispositif comprenant un moteur à combustion interne, alimenté en carburant et qui actionne un alternateur ou une génératrice électrique de manière à produire une puissance électrique $P_1$, $P_i$, $P_n$.

Les différents groupes électrogènes $G_1,..., G_i,..., G_n$ de l'ensemble de production 10 sont alimentés en carburant par une même source de carburant 1 (source qui est constituée d'un ou plusieurs réservoirs de carburant). La source de carburant 1 est munie d'un moyen de mesure 2, réalisé sous la forme d'un débitmètre, et qui délivre une mesure d'un débit total de carburant $D_{mes,k}$ consommé, à un instant d'acquisition $t_k$ donné, par l'ensemble des groupes électrogènes $G_1,..., G_i,..., G_n$ de l'ensemble de production 10.

Chaque groupe électrogène Gi est muni par ailleurs d'un capteur C qui délivre une mesure, $LR_{mes,i,k}$, d'un taux de charge du groupe électrogène considéré, à l'instant d'acquisition $t_k$.

Comme indiqué en préambule, le taux de charge de l'un quelconque des groupes électrogènes de l'ensemble de production, est égal à la puissance électrique $P_{i,k}$ produite par ce groupe électrogène, $G_i$, à l'instant $t_k$ considéré, divisée par sa puissance nominale maximale $P_{nom,i}$.

La puissance nominale maximale $P_{nom,i}$ du groupe électrogène $G_i$ est la puissance électrique maximale qu'il peut produire, telle que spécifiée par le constructeur ou le distributeur du groupe électrogène. Il s'agit de la puissance électrique maximale que le groupe électrogène peut produire sans usure ou détérioration prématurée, et sans s'échauffer au-dessus de la température maximale de fonctionnement pour laquelle il a été conçu.

La mesure $LR_{mes,i,k}$ du taux de charge du groupe électrogène Gi est représentative de ce taux de charge. Il peut s'agir, comme ici, d'une valeur, exprimée sous la forme d'un pourcentage, directement égale au taux de charge en question, à l'instant $t_k$ considéré. En variante, cette mesure pourrait toutefois être égale à la puissance électrique $P_{i,k}$ produite par le groupe électrogène $G_i$ à l'instant $t_k$ considéré (puisque cette puissance est, à un facteur multiplicatif près, égale au taux de charge en question).

L'ensemble de production 10 comprend en outre une unité de pilotage 3 qui commande les différents groupes électrogènes $G_1,..., G_i,..., G_n$. L'unité de pilotage 3 peut commander l'extinction et la mise en fonctionnement de chaque groupe électrogène. Elle peut commander en outre à chaque groupe de fonctionner avec un taux de charge donné. L'unité de pilotage peut être réalisée sous la forme d'un système électronique qui comprend notamment un processeur, une mémoire et un module de communication pour envoyer des instructions aux groupes électrogènes.

Les mesures délivrées par le débitmètre 2 et par les capteurs C sont transmises au dispositif de surveillance 20. Ce dispositif de surveillance 20 peut comprendre :

- un module d'acquisition 21, configuré pour acquérir les mesures en question afin de rassembler des données d'exploitation relatives au fonctionnement de l'ensemble de production,

- une mémoire 22 où enregistrer, entre autres, ces données d'exploitation, et

- un module de calcul 23 comprenant au moins un processeur.

Le dispositif de surveillance 20, qui permet un suivi du fonctionnement de l'ensemble de production 10, peut, comme ici, être intégré à cet ensemble de production. En variante, le dispositif de surveillance pourrait néanmoins être délocalisé, le dispositif de surveillance étant alors distant (de plusieurs kilomètres) de l'ensemble de production, les mesures mentionnées plus haut étant alors transmises au dispositif de surveillance par l'intermédiaire d'un réseau de télécommunication tel qu'internet. En variante encore, le dispositif de surveillance pourrait être partiellement délocalisé, le module de calcul étant délocalisé, mais pas les autres éléments de ce dispositif, par exemple.

Le dispositif de surveillance 20 est programmé pour déterminer des caractéristiques individuelles de consommation en carburant des différents groupes électrogènes $G_1$,..., $G_i$,..., $G_n$ de l'ensemble de production 10, en exécutant le procédé de détermination décrit en détail plus bas.

Et l'unité de pilotage 3 est configurée ici pour piloter les différents groupes électrogènes $G_1$,..., $G_i$,..., $G_n$ de l'ensemble de production 10 en tenant compte de ces caractéristiques individuelles de consommation en carburant.

Le dispositif de surveillance 20 peut par exemple être programmé pour, à chaque fois qu'il vient déterminer de nouvelles caractéristiques individuelles de consommation, transmettre ces caractéristiques mises à jour au dispositif de pilotage 3 (pour que le dispositif de pilotage en tienne compte lors du pilotage des groupes électrogènes). Le dispositif de surveillance pourrait aussi être programmé pour, à chaque fois qu'il vient déterminer de nouvelles caractéristiques individuelles de consommation, enregistrer ces caractéristiques mises à jour dans une mémoire accessible à distance (par exemple via internet), cette mémoire jouant le rôle d'un serveur de données, que le dispositif de pilotage 3 vient régulièrement interroger.

Quoiqu'il en soit, les caractéristiques individuelles de consommation en carburant des différents groupes électrogènes $G_1$,..., $G_i$,..., $G_n$ de l'ensemble de production 10 sont déterminées, par le dispositif de surveillance 20, sur la base de données d'exploitation de l'ensemble de production d'électricité 10, conformément au procédé de détermination que l'on va maintenant décrire.

Ce procédé de détermination comprend les étapes suivantes (voir la figure 2) :

- a) acquérir des données d'exploitation qui, pour différents instants d'acquisition $t_k$ répartis au cours d'une période d'acquisition donnée, regroupent :

  - la mesure du débit total de carburant $D_{mes,k}$ consommé, à l'instant d'acquisition ($t_k$) considéré, et

  - pour chaque groupe électrogène Gi de l'ensemble de production 10, la mesure du taux de charge $LR_{mes,i,k}$ de ce groupe électrogène $G_i$, à l'instant d'acquisition $t_k$ considéré, et

- b) déterminer les caractéristiques individuelles de consommation $SFC_{1,1}$,..., $SFC_{i,j}$,..., $SFC_{n,m}$ des différents groupes électrogènes $G_1$,..., $G_i$,..., $G_n$ de l'ensemble de production 10, par une procédure de minimisation d'un écart cumulé Obj qui tient compte d'un ensemble d'écarts instantanés $EC_k$ associés respectivement aux différents instants d'acquisition $t_k$, chaque écart instantané $EC_k$ étant un écart, pour l'instant d'acquisition t considéré, entre :

  - d'une part, la mesure du débit total de carburant $D_{mes,k}$, et

  - d'autre part, une estimation du débit total de carburant $D_{sim,k}$ consommé par ledit ensemble de production d'électricité 10, ladite estimation du débit total $D_{sim,k}$ étant égale à la somme de débits individuels estimés $d_{sim,i,k}$, associés respectivement aux différents groupes électrogènes $G_i$ de l'ensemble de production d'électricité.

Chaque débit individuel estimé $d_{sim,i,k}$ étant déterminé sur la base :

- de la mesure du taux de charge $LR_{mes,i,k}$ du groupe électrogène Gi considéré, à l'instant d'acquisition $t_k$ considéré, et

- des caractéristiques individuelles de consommation $SFC_{i,1}$ , ..., $SFC_{i,j}$ ,..., $SFC_{i,m}$ en carburant du groupe électro-

gène $G_i$ considéré, qui sont des caractéristiques estimées, dont les valeurs sont ajustées pour minimiser l'écart cumulé en question.

Comme expliqué dans la partie intitulée « résumé de l'invention », pour chaque groupe électrogène de l'ensemble de production, les caractéristiques individuelles de consommation du groupe électrogène Gi considéré, $SFC_{i,1}$ , ..., $SFC_{i,j}$ , ..., $SFC_{i,m}$, sont représentatives de la consommation spécifique en carburant de ce groupe électrogène Gi, et pour différents taux de charge $LR_1$,..., $LR_j$,..., $LR_m$.

Ici, pour chaque groupe électrogène, les caractéristiques individuelles de consommation $SFC_{i,1}$, ..., $SFC_{i,j}$ , ..., $SFC_{i,m}$ sont directement égales à des valeurs de consommation spécifique en carburant de ce groupe électrogène $G_i$ correspondant respectivement aux différents taux de charge $LR_1$,..., $LR_j$,..., $LR_m$.

Pour chaque groupe électrogène, les caractéristiques individuelles en question regroupent ainsi plusieurs couples de valeurs ($LR_j$, $SFC_{i,j}$), chaque couple rassemblant une valeur de taux de charge $LR_j$, et une valeur correspondante de consommation spécifique en carburant $SFC_{i,j}$ qui est égale à la consommation spécifique en carburant du groupe électrogène $G_i$ lorsque ce groupe électrogène fonctionne avec un taux de charge ayant cette valeur $LR_j$.

Chacun de ces couples de valeurs est repéré par un indice entier j compris entre 1 et m, où m est le nombre de valeurs différentes de taux de charge pris en compte pour caractériser la consommation énergétique du groupe électrogène. Ici, par exemple, m est égal à 25 et les 25 valeurs de taux de charge $LR_1$,..., $LR_j$,..., $LR_m$ sont réparties entre 0% ($LR_1$=0%) et 87% ($LR_m$ =87%). La valeur supérieure $LR_m$ des taux de charges pour lesquels on détermine les caractéristiques individuelles de consommation $SFC_{i,1}$ , ..., $SFC_{i,j}$ , ..., $SFC_{i,m}$ est égale à 87%, ici, car il s'agit de la plus grande valeur de taux de charge mesurée au cours de la période d'acquisition. Mais cette valeur supérieure $LR_m$ pourrait être plus grande, ou plus petite, selon les valeurs de taux de charge pour lesquelles les groupes électrogènes ont fonctionné, lors de la période d'acquisition (elle pourra être égale à 90%, par exemple, si l'un au moins des groupes électrogènes fonctionne effectivement avec un taux de charge aussi élevé, pendant la période d'acquisition).

Etape a)

La période d'acquisition, tout au long de laquelle sont acquises les mesures de débit total $D_{mes,k}$ et de taux de charge $LR_{mes,i,k}$, comprend plusieurs périodes d'exploitations distinctes. La puissance électrique totale $P_{tot,k}$ produite par l'ensemble de production 10 est répartie de manières différentes entre les groupes électrogènes $G_1$,.., $G_i$, ..., $G_n$ de l'ensemble de production 10 au cours de ces différentes périodes d'exploitation. Autrement formulé, les groupes électrogènes de l'ensemble de production fonctionnent avec des taux de charges qui varient les uns par rapport aux autres, d'une période d'exploitation à l'autre.

Comme expliqué dans la partie intitulée « résumé de l'invention », faire varier la manière dont est répartie la charge totale, d'une période d'exploitation à l'autre, favorise une détermination précise des caractéristiques *individuelles* de consommation en carburant des différents groupes électrogènes.

De préférence, la période d'acquisition comprend au moins autant de périodes d'exploitation différentes que de groupes électrogènes. Et, pour chaque groupe électrogène :

- au cours de l'une au moins desdites périodes d'exploitation, le groupe électrogène considéré fonctionne avec un taux de charge inférieure à 50% (le groupe électrogène pouvant même, de préférence, être éteint au cours de cette période d'exploitation),

- tandis qu'au cours d'une autre desdites périodes d'exploitation, le groupe électrogène considéré fonctionne avec un taux de charge supérieur à 70%.

A titre d'exemple, pour un ensemble de production d'électricité comprenant trois groupes électrogènes différents, la période d'acquisition pourrait comprendre trois périodes d'exploitation distinctes, au cours desquelles un premier, un deuxième, puis respectivement un troisième de ces groupes électrogènes est éteint tandis que les deux autres produisent la puissance électrique à fournir. Comme déjà indiqué, ce type de fonctionnement, avec une alternance entre groupes électrogènes, favorise une détermination précise des caractéristiques individuelles de consommation des différentes groupes électrogènes de l'ensemble de production.

La période d'acquisition peut par exemple durer une journée, ou plus. Cela est intéressant car la puissance électrique totale que doit fournir un tel ensemble de production d'électricité varie généralement assez fortement au cours d'une journée. Acquérir des mesures pendant une journée ou plus permet donc de disposer de données d'exploitation correspondant à des valeurs de taux de charge assez variées, ce qui, là encore, favorise une détermination précise des caractéristiques individuelles de consommation des différents groupes électrogènes.

On peut même prévoir que la durée d'acquisition dure plusieurs jours, et que les différentes périodes d'exploitation durent chacune une journée, ou plus.

En revanche, il est préférable que la durée d'acquisition ne dure pas plus de deux mois. En effet, si la période d'acquisition est trop longue, un ou plusieurs des groupes électrogènes est susceptible de subir un vieillissement au cours de la période d'acquisition, rendant les caractéristiques individuelles obtenues plus difficiles à interpréter.

Une période d'acquisition dont la durée est comprise entre une semaine et 8 semaines est donc bien adaptée.

Quant au pas de temps $\Delta t$, il peut par exemple être compris entre 1 et 30 minutes, ou, mieux, entre 3 et 15 minutes. Ce pas de temps $\Delta t$ est égal à la durée qui sépare deux instants d'acquisition successifs $t_k$ et $t_{k+1}$ ($\Delta t = t_{k+1} - t_k$). La période d'acquisition comprend un nombre total d'instants d'acquisition $t_k$ qui est noté p. L'indice entier k qui repère chaque instant d'acquisition $t_k$ est donc compris entre 1 et p, ici.

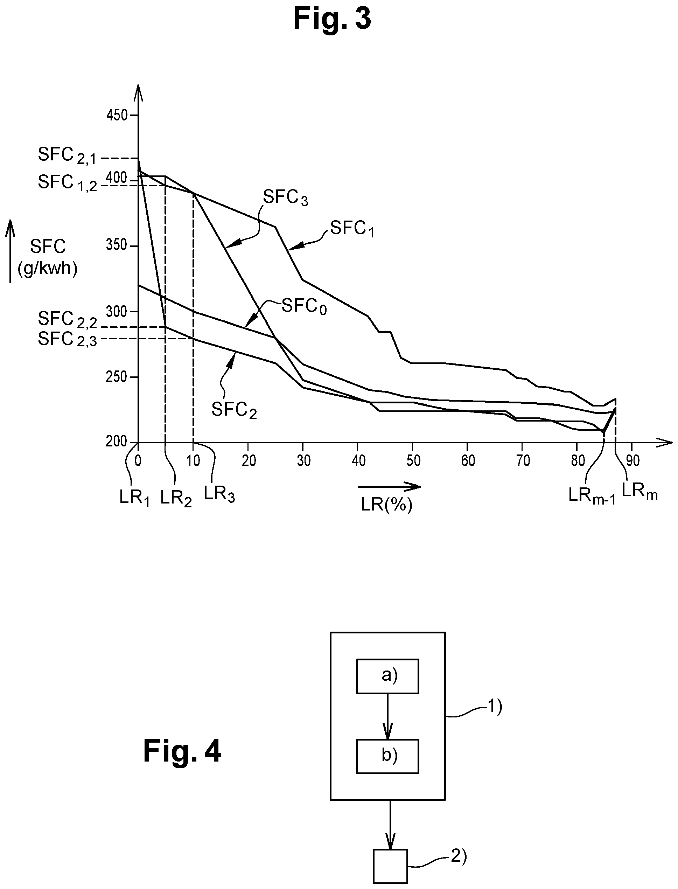

A titre d'exemple, pour les résultats présentés plus bas en référence à la figure 3, la période d'acquisition a une durée de 19 jours, et le pas de temps est de 5 minutes.

Etape b)

Ici, l'écart cumulé Obj, qui est minimisé pour déterminer les caractéristiques individuelles de consommation des différents groupes électrogènes, est égal à la somme desdits écarts instantanés $EC_k$, comme indiqué par la formule F1 ci-dessous :

$$Obj = \sum_{k=1}^{k=p} EC_k \qquad (F1) \ .$$

En variante, l'écart cumulé Obj pourrait prendre en compte ces différents écarts instantanés $EC_k$ d'une autre manière, par exemple sous la forme d'une racine carrée d'une somme des carrés de ces écarts instantanés. Mais calculer cet écart cumulé comme la somme des écarts instantanés est néanmoins plus simple et facilite donc la procédure de minimisation mise en œuvre à l'étape b) (d'autant que l'entier p a une valeur relativement élevée, typiquement supérieure à 1000).

Par ailleurs, chaque écart individuel $EC_k$ est égal, ici, à la valeur absolue de la différence, entre, d'une part, la mesure du débit total de carburant $D_{mes,k}$ consommé par l'ensemble de production d'électricité, à l'instant d'acquisition $t_k$ considéré, et d'autre part l'estimation du débit total de carburant $D_{sim,k}$ mentionnée plus haut, soit :

$$EC_k = \left| D_{mes,k} - D_{sim,k} \right| \qquad (F2) \ .$$

En variante, l'écart instantané $EC_k$ pourrait néanmoins être calculé d'une autre manière, en fonction de la différence $D_{mes,k} - D_{sim,k}$ (cet écart pouvant par exemple être égal au carré, ou au cube de la valeur absolue de cette différence).

Comme déjà indiqué, l'estimation du débit total $D_{sim,k}$ est égale à la somme des débits individuels estimés $d_{sim,i,k}$, associés respectivement aux différents groupes électrogènes $G_i$ de l'ensemble de production 10 :

$$D_{sim,k} = \sum_{i=1}^{i=n} d_{sim,i,k} \qquad (F3) \ .$$

Et, ici, chaque débit individuel estimé $d_{sim,i,k}$ est déterminé en :

- déterminant une consommation spécifique en carburant SFC_interpol correspondant à la mesure du taux de charge $LR_{mes,i,k}$ du groupe électrogène Gi considéré à l'instant d'acquisition $t_k$ considéré, par interpolation, à partir des caractéristiques individuelles de consommation $SFC_{i,1}$ ,..., $SFC_{i,j}$ ,..., $SFC_{i,m}$ du groupe électrogène $G_i$ considéré, puis en

- multipliant ladite consommation spécifique en carburant SFC_interpol par ladite mesure du taux de charge $LR_{mes,i,k}$, et par la puissance nominale maximale $P_{nom,i}$ du groupe électrogène Gi considéré.

Ici, chaque débit individuel estimé $d_{sim,i,k}$ est donc déterminé conformément à la formule F4 suivante :

$$d_{sim,i,k} = P_{nom,i} \times LR_{mes,i,k} \times SFC\_interpol(SFC_{i,1}, \ldots, SFC_{i,m}; LR_{mes,i,k}) \qquad (F4).$$

L'interpolation en question permet de gagner en précision, lors de la détermination des caractéristiques individuelles de consommation. En effet, la mesure de taux de charge $LR_{mes,i,k}$, acquise à l'instant $t_k$, n'est pas nécessairement égale à l'une des valeurs discrètes de taux de charge, $LR_1, \ldots, LR_j, \ldots, LR_m$ associées aux valeurs de consommation spécifiques à déterminer $SFC_{i,1}, \ldots, SFC_{i,j}, \ldots, SFC_{i,m}$.

L'interpolation en question est par exemple une interpolation linéaire. Dans ce cas, lorsque la mesure de taux de charge $LR_{mes,i,k}$ est comprise entre les deux valeurs successives de taux de charge $LR_{j'}$ et $LR_{j'+1}$, la consommation spécifique en carburant SFC_interpol peut alors être déterminée conformément à la formule F5 suivante :

$$SFC\_interpol = SFC_{i,j'} + (LR_{mes,i,k} - LR_{j'}) \times \frac{(SFC_{i,j'+1} - SFC_{i,j'})}{LR_{j'+1} - LR_{j'}} \qquad (F5).$$

Les caractéristiques individuelles de consommation $SFC_{i,1}, \ldots, SFC_{i,j}, \ldots, SFC_{n,m}$ des différents groupes électrogènes $G_1, \ldots, G_i, \ldots, G_n$ de ensemble de production 10 sont déterminées, au cours de la procédure de minimisation mentionnée plus haut, en respectant la contrainte suivante : pour chaque groupe électrogène $G_i$, la consommation spécifique en carburant du groupe électrogène est décroissante en fonction du taux de charge du groupe électrogène, sur au moins un intervalle qui s'étend d'un premier seuil de taux de charge $LR_{T1}$ jusqu'à un deuxième seuil de taux de charge $LR_{T2}$.

Cette contrainte, notée Cstr, se traduit par la formule F6 suivante :

$$Cstr : \{ SFC_{i,j} \geq SFC_{i,j+1} \ \forall j \in [j1 : j2], \forall i \in [1 : n] \} \qquad (F6)$$

où les entiers j1 et j2 correspondent respectivement au premier et au deuxième seuil de taux de charge $LR_{T1}$ et $LR_{T2}$ : $LR_{j1} = LR_{T1}$ et $LR_{j2} = LR_{T2}$.

L'intérêt de la prise en compte de cette contrainte, lors de la procédure de minimisation de l'écart cumulé Obj, a été présenté en détail dans la partie relative au « résumé de l'invention ».

Ici, les premier et deuxième seuil de taux de charge $LR_{T1}$ et $LR_{T2}$, qui définissent la plage sur laquelle la consommation spécifique en carburant du groupe électrogène décroit, dépendent des générateurs considérés et peuvent par exemple être choisis comme suit : $LR_{T1}=0\%$ (soit j1 =1), et $LR_{T2}=87\%$ (soit j2=m). En effet, pour le type de groupes électrogènes de cet ensemble de production d'électricité utilisé en exemple, on attend une décroissance de la consommation spécifique en carburant, en fonction du taux de charge, sur toute cette gamme de taux de charge (et, ensuite, une remontée de la consommation spécifique en carburant, sur la plage de taux de charge 87% - 100%, plage que l'on évite en général).

La procédure de minimisation mentionnée plus haut consiste donc, ici, à chercher les caractéristiques individuelles de consommation $SFC_{i,1}, \ldots, SFC_{i,j}, \ldots, SFC_{n,m}$ qui, pour les données d'exploitation acquises, permettent de minimiser, ou tout au moins de réduire l'écart cumulé Obj, tout en respectant la contrainte Cstr.

La procédure de minimisation peut être réalisée au moyen de toute technique de minimisation sous contraintes (en l'occurrence sous contrainte linéaire d'inégalité) d'une fonction non-linéaire de plusieurs variables connue de l'homme du métier (les variables en question étant les caractéristiques individuelles de consommation des différents groupes électrogènes). A titre d'exemple, cette procédure de minimisation peut être mise en œuvre en utilisant la fonction « fmincon » du langage de script « Matlab » développé par la société « The MathWorks® ».

Les caractéristiques individuelles de consommation ont des valeurs données, initialement, avant de lancer la procédure de minimisation. En d'autres termes, cette minimisation débute à partir de valeurs initiales données. Ces valeurs initiales peuvent correspondre par exemple à des valeurs fournies par un constructeur des groupes électrogènes. Elles peuvent aussi être égales aux dernières valeurs connues pour ces caractéristiques individuelles, obtenues lors d'une exécution antérieure du procédé de détermination et enregistrées dans une mémoire du dispositif de surveillance 20.

On notera que la procédure de minimisation en question peut conduire à une valeur de l'écart cumulé Obj qui n'est pas nécessairement un minimum absolu, ni même nécessairement un minimum local, mais qui est en tout cas plus petite que ce qui serait obtenu sans ajustement des caractéristiques individuelles de consommation des groupes électrogènes (c'est à dire en se basant sur les valeurs initiales de ces caractéristiques, sans exécuter l'étape b). De manière optionnelle, la procédure de minimisation en question pourrait s'arrêter lorsque l'écart cumulé Obj devient inférieur à une valeur seuil, cette valeur seuil étant par exemple égale à 1% de la somme, de k=1 à p, des mesures de débit $D_{mes,k}$ (les caractéristiques individuelles de consommation obtenues à ce stade étant alors considérées comme fiables, même si la valeur de l'écart cumulé n'est pas rigoureusement minimale).

La figure 3 montre un exemple de résultat obtenu, grâce au procédé qui vient d'être décrit, pour un ensemble de production comportant 3 groupes électrogènes $G_1$, $G_2$ et $G_3$ (c'est-à-dire pour lequel n=3).

Sur la figure 3, on a ainsi représenté 3 courbes, $SFC_1$, $SFC_2$ et $SFC_3$ qui montrent, pour ces 3 groupes électrogènes $G_1$, $G_2$, $G_3$, l'évolution de la consommation spécifique en carburant du groupe électrogène considéré (exprimée en gramme par kilowattheure, g/kWh), en fonction du taux de charge LR (exprimé en pourcents, %).

Chacune de ces courbes rassemble, pour le groupe électrogène considéré, l'ensemble des valeurs de consommation spécifique $SFC_{i,1}$, ... , $SFC_{i,m}$ obtenues à l'issu du procédé de détermination. A titre d'exemple, le premier point de la courbe $SFC_2$ est un point de coordonnées ($LR_1$ ; $SFC_{2,1}$), le deuxième point de cette courbe est un point de coordonnées ($LR_2$, $SFC_{2,2}$), et ainsi de suite (voir la figure 3).

Sur la figure 3, on a également représenté une courbe $SFC_O$, qui montre les valeurs initiales de consommation spécifique en carburant qui servent de point de départ lors de l'exécution de la procédure de minimisation de l'étape b).

Dans cet exemple, les 3 groupes électrogènes $G_1$, $G_2$ et $G_3$ sont du même modèle, ont été installés à la même date, et ont fonctionné, depuis leur installation, pendant des durées totales comparables.

On constate pourtant que leurs caractéristiques individuelles de consommation en carburant, ici leurs courbes de consommation spécifique $SFC_1$, $SFC_2$ et $SFC_3$ sont bien différentes les unes des autres.

Le premier groupe électrogène $G_1$ a en effet une consommation spécifique en carburant nettement plus importante que les deux autres groupes électrogènes $G_2$ et $G_3$. Par exemple, pour un taux de charge de 50%, on constate que le premier groupe électrogène $G_1$ a une consommation spécifique en carburant de 260 g/kWh tandis que les deux autres groupes ont des consommations spécifiques de 230 g/kWh et de 224 g/kWh respectivement.

Cet exemple illustre un des intérêts qu'il y a à réaliser ainsi une sorte de surveillance, en situation, des consommations spécifiques en carburant des groupes électrogènes de l'ensemble de production. En effet, une fois obtenues, les caractéristiques individuelles de consommation de ces groupes permettent, comme ici, de détecter que l'un des groupes électrogène (ici le premier groupe $G_1$) a une consommation spécifique anormalement élevée, ce qui montre notamment qu'une opération de maintenance serait souhaitable pour ce groupe électrogène.

Pour cet exemple, après minimisation (minimisation au terme de laquelle les courbes $SFC_1$, $SFC_2$, $SFC_3$ ont été obtenues), la valeur obtenue pour l'écart cumulé Obj est inférieur à 0,1%. Pour cet exemple, la période d'acquisition dure 19 jours, comme indiqué plus haut. Et au cours de cette même période d'acquisition, pour des durées courtes, inférieure à 2 heures environ, un écart moyen inférieur à 1% a été obtenu (les caractéristiques individuelles en question restant égales à celles obtenues en minimisant l'écart cumulé global en question). En outre, une fois que ces consommations spécifiques en carburant $SFC_1$, $SFC_2$, $SFC_3$ ont été déterminées (par minimisation) et fixées, il s'avère que l'écart cumulé entre la mesure du débit total et l'estimation de ce débit, reste inférieur à 2% environ pour une période, ultérieure, de 19 jours environ, alors que les consommations spécifiques en question conservent alors des valeurs fixes, ce qui montre que les consommations spécifiques ainsi obtenues ont une valeur prédictive, et correspondent donc bien aux consommations spécifiques réelles (effectives) des groupes électrogènes, telles qu'elles pourraient être mesurées en retirant chaque groupe de l'ensemble de production pour réaliser des essais de consommation.

On remarquera que pour déterminer les caractéristiques individuelles de consommation des groupes électrogènes avec une bonne précision, il a été nécessaire de considérer que ces groupes électrogènes pouvaient avoir des caractéristiques individuelles différentes, alors même qu'il s'agit de groupes électrogènes du même modèle et qui ont été installés à la même date, ce qui parait particulièrement surprenant a priori.

On notera d'ailleurs que les caractéristiques individuelles de consommation des différents groupes électrogènes sont considérées ici comme indépendantes les unes des autres (celles associées à un groupe électrogène sont indépendantes de celle associées à un autre groupe électrogène), lors de la procédure de minimisation, et cela même si les groupes électrogènes en question sont d'un même modèle, et ont été installés à la même date. En d'autres termes, il y a un jeu différent de caractéristiques individuelles pour chaque groupe électrogène de l'ensemble de production, et lors de la procédure de minimisation, le nombre de jeux de caractéristiques individuelles différents, qui sont ajustés lors de la procédure de minimisation, est égal au nombre n de groupes électrogènes de l'ensemble de production 10.

Le dispositif de surveillance 20 est programmé par ailleurs pour exécuter le procédé de détection d'un besoin de maintenance décrit ci-dessous.

Au cours de ce procédé, le dispositif de surveillance 20 exécute les étapes suivantes (figure 4) :

- 1) détermination des caractéristiques individuelles de consommation en carburant des différents groupes électrogènes $G_1$,..., $G_i$,..., $G_n$ de l'ensemble de production 10 d'électricité, ladite détermination étant réalisée conformément au procédé de détermination qui a été décrit plus haut, et

- 2) identification, parmi lesdits groupes électrogènes, d'un ou plusieurs groupes électrogènes pour lesquels une différence, entre les caractéristiques individuelles de consommation du groupe électrogène $G_i$ considéré, détermi-

nées à l'étape 1) et des caractéristiques individuelles de référence $SFC_{ref,i}$, est supérieure à un seuil donné, le ou les groupes électrogènes en question étant alors identifiés comme nécessitant une maintenance.

En pratique, le seuil en question peut par exemple être égal à 5%, en valeur relative, ou à 10 ou encore 20%. En pratique, une détection basée sur un seuil de 10% s'avère à la fois sensible et fiable.

La différence entre les caractéristiques individuelles de consommation du groupe électrogène $G_i$ considéré, et ses caractéristiques individuelles de référence $SFC_{ref,i}$, est de préférence une différence cumulée, obtenue par sommation (par intégration) sur l'ensemble des taux de charges considérés.

Les caractéristiques individuelles de référence $SFC_{ref,i}$ du groupe électrogène $G_i$ peuvent être égales à une moyenne des caractéristiques individuelles de consommation qui ont été déterminées précédemment, à l'étape 1), pour les *autres* groupes électrogènes de l'ensemble de production d'électricité (c'est-à-dire pour les groupes autres que le groupe $G_i$, dont on cherche à déterminer s'il doit subir une opération de maintenance).

Déterminer les caractéristiques individuelles de référence $SFC_{ref,i}$ de cette manière amènerait par exemple, pour la situation correspondant à l'exemple décrit plus haut en référence à la figure 3, à déterminer que le premier groupe G1 nécessite une opération de maintenance, puisque sa courbe de consommation spécifique $SFC_1$ est nettement supérieure à la moyenne des courbes de consommation spécifique $SFC_2$ est $SFC_3$ des deux autres groupes électrogènes $G_2$ et $G_3$.

En variante, les caractéristiques individuelles de référence $SFC_{ref,i}$ en question pourraient, pour chaque groupe électrogène $G_i$, être égales à une moyenne, des caractéristiques individuelles de consommation qui ont été déterminées précédemment, à l'étape 1), pour l'ensemble des groupes électrogènes $G_1$, ..., $G_i$, ..., $G_n$ de l'ensemble de production 10 (auquel cas les caractéristiques individuelles de référence $SFC_{ref,i}$ sont les mêmes quel que soit le groupe électrogène).

Les caractéristiques individuelles de référence $SFC_{ref,i}$ pourraient aussi être des caractéristiques fournies par un constructeur du groupe électrogène.

Pour chaque groupe électrogène de l'ensemble de production, les caractéristiques individuelles de référence $SFC_{ref,i}$, pourraient aussi être égales à des caractéristiques individuelles de consommation du groupe électrogène Gi considéré

- qui ont été déterminées, par exemple au moyen du procédé de détermination décrit plus haut, juste après avoir installé le groupe électrogène Gi considéré, ou juste après une opération de maintenance de ce groupe électrogène, ou encore lors d'une période temporelle précédente non-séparée de la période d'acquisition par une opération de maintenance (ce qui permet de détecter un dérive des performances du groupe électrogène),

- et qui ont été enregistrées (par exemple dans la mémoire 22 du dispositif de surveillance) pour servir ensuite de caractéristiques individuelles de référence pour ce groupe électrogène.

Par « juste après », on entend plus précisément dans un délai de 3 semaine maximum après l'installation ou la maintenance du groupe électrogène.

Par ailleurs, comme indiqué plus haut, le dispositif de pilotage 3 est programmé pour piloter les différents groupes électrogènes $G_1$, ..., $G_i$, ..., $G_n$ en tenant compte des caractéristiques individuelles de consommation en carburant de ces différents groupes électrogènes, déterminées précédemment grâce au procédé de détermination qui a été décrit plus haut.

Ce pilotage est réalisé plus particulièrement de manière à ce que les groupes électrogènes fonctionnent avec des taux de charges respectifs qui sont déterminés sur la base des caractéristiques individuelles de consommation en carburant de ces groupes électrogènes (précédemment déterminées).

On peut par exemple prévoir de déterminer, à chaque instant, les taux de charges respectifs auxquels piloter les différentes groupes électrogènes, de manière à fournir une puissance totale demandée tout en minimisant la consommation totale en carburant de l'ensemble de production 10. Pour pouvoir minimiser cette consommation totale, cette détermination est basée sur les caractéristiques individuelles de consommation de ces différents groupes électrogènes (caractéristiques obtenues précédemment, grâce au procédé de détermination décrit plus haut). Cette détermination peut par exemple être réalisée conformément au procédé décrit dans la demande de brevet EP19207140, non encore publiée à la date de dépôt de la présente demande de brevet, et appartenant au demandeur.

En variante, ou en complément, le dispositif de pilotage 3 pourrait être programmé pour maintenir éteint autant que possible tout groupe électrogène pour lequel un besoin de maintenance a été détecté (grâce au procédé de détection décrit plus haut). Dans ce cas, tant que la puissance électrique totale demandée peut être fournie par les autres groupes électrogènes (i.e. : ceux qui ne nécessitent pas de maintenance), le ou les groupes électrogènes nécessitant une maintenance restent éteints.

**Revendications**

1. Procédé de détermination de caractéristiques individuelles de consommation en carburant de différents groupes électrogènes ($G_1$, $G_i$, $G_n$) d'un ensemble de production (10) d'électricité,

- les caractéristiques individuelles de consommation ($SFC_{i,1}$, $SFC_{i,j}$, $SFC_{i,m}$) associées à chaque groupe électrogène ($G_i$) étant représentatives de la consommation spécifique en carburant du groupe électrogène ($G_i$) considéré, pour différents taux de charge ($LR_1$, $LR_j$, $LR_m$) du groupe électrogène,
- les différents groupes électrogènes ($G_1$, $G_i$, $G_n$) dudit ensemble de production (10) étant alimentés en carburant par une même source de carburant (1) munie d'un moyen de mesure (2) qui délivre une mesure d'un débit total de carburant ($D_{mes,k}$) consommé par l'ensemble des groupes électrogènes dudit ensemble de production (10),
- chaque groupe électrogène étant muni d'un capteur (C) qui délivre une mesure d'un taux de charge ($LR_{mes,i,k}$) du groupe électrogène considéré ($G_i$),
- le procédé comprenant les étapes suivantes :

a) acquérir des données d'exploitation qui, pour différents instants d'acquisition ($t_k$) répartis au cours d'une période d'acquisition donnée, regroupent :

- la mesure du débit total de carburant ($D_{mes,k}$) consommé, à l'instant d'acquisition ($t_k$) considéré, et
- pour chaque groupe électrogène de l'ensemble de production, la mesure du taux de charge ($LR_{mes,i,k}$) du groupe électrogène ($G_i$) considéré, à l'instant d'acquisition ($t_k$) considéré, et

b) déterminer les caractéristiques individuelles de consommation ($SFC_{1,1}$, $SFC_{i,j}$, $SFC_{n,m}$) des différents groupes électrogènes ($G_1$, $G_i$, $G_n$) de l'ensemble de production, par une procédure de minimisation d'un écart cumulé (Obj) qui tient compte d'un ensemble d'écarts instantanés ($EC_k$) associés respectivement aux différents instants d'acquisition ($t_k$), chaque écart instantané ($EC_k$) étant un écart, pour l'instant d'acquisition ($t_k$) considéré, entre :

- d'une part, la mesure du débit total de carburant ($D_{mes,k}$), et
- d'autre part, une estimation du débit total de carburant ($D_{sim,k}$) consommé par ledit ensemble de production (10) d'électricité, ladite estimation du débit total ($D_{sim,k}$) étant égale à la somme de débits individuels estimés ($d_{sim,i,k}$), associés respectivement aux différents groupes électrogènes ($G_i$) de l'ensemble de production (10), chaque débit individuel estimé ($d_{sim,i,k}$) étant déterminé sur la base :

- de la mesure du taux de charge ($LR_{mes,i,k}$) du groupe électrogène ($G_i$) considéré, à l'instant d'acquisition ($t_k$) considéré, et
- des caractéristiques individuelles de consommation ($SFC_{i,1}$, $SFC_{i,j}$, $SFC_{i,m}$) en carburant du groupe électrogène ($G_i$) considéré,
ladite période d'acquisition comprenant plusieurs périodes d'exploitations distinctes, une puissance électrique totale ($P_{tot,k}$) produite par l'ensemble de production (10) étant répartie de manières différentes entre les groupes électrogènes ($G_1$, $G_i$, $G_n$) de l'ensemble de production au cours des différentes périodes d'exploitation.

2. Procédé selon la revendication précédente, dans lequel les caractéristiques individuelles de consommation ($SFC_{i,1}$, $SFC_{i,j}$, $SFC_{i,m}$) des différents groupes électrogènes ($G_1$, $G_i$, $G_n$) dudit ensemble de production sont déterminées, au cours de ladite procédure de minimisation, en respectant la contrainte suivante : pour chaque groupe électrogène, la consommation spécifique en carburant ($SFC_i$) du groupe électrogène ($G_i$) est décroissante en fonction du taux de charge du groupe électrogène, sur au moins un intervalle qui s'étend d'un premier seuil de taux de charge ($LR_{T1}$) jusqu'à un deuxième seuil de taux de charge (LRT2).

3. Procédé selon la revendication précédente, dans lequel le premier seuil de taux de charge ($LR_{T1}$) est inférieur ou égal à 10%, et dans lequel le deuxième seuil de taux de charge ($LR_{T2}$) est compris entre 70% et 95%.

4. Procédé selon l'une quelconque des revendications précédentes, dans lequel l'écart cumulé (Obj) est égal ou proportionnel à la somme desdits écarts instantanés ($EC_k$).

5. Procédé selon l'une quelconque des revendications précédentes, dans lequel chaque débit individuel estimé ($d_{sim,i,k}$) est déterminé en :

- déterminant une consommation spécifique en carburant (SFC_Interpol) correspondant à la mesure du taux de charge ($LR_{mes,i,k}$) du groupe électrogène ($G_i$) considéré à l'instant d'acquisition ($t_k$) considéré, par interpolation, à partir des caractéristiques individuelles de consommation ($SFC_{i,1}$, $SFC_{i,j}$, $SFC_{i,m}$) du groupe électrogène ($G_i$) considéré, puis en

- multipliant ladite consommation spécifique en carburant (SFC_Interpol) par ladite mesure du taux de charge ($LR_{mes,i,k}$) et par une puissance nominale maximale ($P_{nom,i}$) du groupe électrogène ($G_i$) considéré.

**6.** Procédé selon l'une quelconque des revendications précédentes, dans lequel la période d'acquisition comprend au moins autant de périodes d'exploitation différentes que de groupes électrogènes.

**7.** Procédé selon l'une quelconque des revendications précédentes, dans lequel ladite période d'acquisition dure une journée au moins.

**8.** Procédé selon l'une quelconque des revendications précédentes, dans lequel ladite période d'acquisition dure plusieurs jours et dans lequel au moins certaines desdites périodes d'exploitation durent chacune une journée ou plus.

**9.** Procédé selon l'une quelconque des revendications précédentes, dans lequel, pour chaque groupe électrogène dudit ensemble de production (10) d'électricité :

- au cours de l'une au moins desdites périodes d'exploitation, le groupe électrogène ($G_i$) considéré fonctionne avec un taux de charge ($LR_{mes,i,k}$) inférieur à 50%, et
- au cours d'une autre desdites périodes d'exploitation, le groupe électrogène ($G_i$) considéré fonctionne avec un taux de charge ($LR_{mes,i,k'}$) supérieur à 70%.

**10.** Procédé de pilotage d'un ensemble de production (10) d'électricité qui comporte plusieurs groupes électrogènes ($G_1$, $G_i$, $G_n$), le procédé comprenant :

- une détermination de caractéristiques individuelles de consommation en carburant ($SFC_{1,1}$, $SFC_{i,j}$, $SFC_{n,m}$), pour les différents groupes électrogènes ($G_1$, $G_i$, $G_n$) de l'ensemble de production (10) d'électricité, ladite détermination étant réalisée conformément au procédé de détermination selon l'une quelconque des revendications précédentes, et
- un pilotage desdits groupes électrogènes ($G_1$, $G_i$, $G_n$), de manière à qu'ils fonctionnent avec des taux de charges respectifs déterminés sur la base des caractéristiques individuelles de consommation en carburant ($SFC_{1,1}$, $SFC_{i,j}$, $SFC_{n,m}$) précédemment déterminées.

**11.** Procédé de détection d'un besoin de maintenance d'un ou plusieurs groupes électrogènes d'un ensemble de production (10) d'électricité comportant plusieurs groupes électrogènes ($G_1$, $G_i$, $G_n$), le procédé comprenant :

- 1) une détermination de caractéristiques individuelles de consommation en carburant ($SFC_{1,1}$, $SFC_{i,j}$, $SFC_{n,m}$), pour les différents groupes électrogènes ($G_1$, $G_i$, $G_n$) de l'ensemble de production d'électricité, ladite détermination étant réalisée conformément au procédé de détermination selon l'une quelconque des revendications 1 à 9, et
- 2) une identification, parmi lesdits groupes électrogènes ($G_1$, $G_i$, $G_n$), d'un ou plusieurs groupes électrogènes pour lesquels une différence entre :

  ◦ les caractéristiques individuelles de consommation ($SFC_{i,1}$, $SFC_{i,j}$, $SFC_{i,m}$) du groupe électrogène ($G_i$) considéré, déterminées à l'étape 1), et
  ◦ des caractéristiques individuelles de référence ($SFC_{ref,i}$) est supérieure à un seuil donné, ledit ou lesdits groupes électrogènes ($G_i$) étant alors identifiés comme nécessitant une maintenance.

**12.** Procédé de détection d'un besoin de maintenance selon la revendication précédente, dans lequel les caractéristiques individuelles de référence ($SFC_{ref,i}$) sont égales, pour chaque groupe électrogène ($G_i$), à :

- une moyenne des caractéristiques individuelles de consommation ($SFC_{1,1}$, $SFC_{n,m}$) ayant été déterminées, à l'étape 1), pour les autres groupes électrogènes ($G_1$, $G_n$) dudit ensemble de production d'électricité, ou à
- une moyenne des caractéristiques individuelles de consommation ($SFC_{1,1}$, $SFC_{i,j}$, $SFC_{n,m}$) ayant été déterminées, à l'étape 1), pour l'ensemble des groupes électrogènes ($G_1$, $G_i$, $G_n$) dudit ensemble de production (10) d'électricité, ou à

- des caractéristiques individuelles de consommation du groupe électrogène considéré, fournies par un constructeur du groupe électrogène, ou à
- des caractéristiques individuelles de consommation du groupe électrogène considéré, qui ont été déterminées juste après avoir installé ce groupe électrogène ou juste après une opération de maintenance de ce groupe électrogène, ou encore lors d'une période temporelle précédente non-séparée de ladite période d'acquisition par une opération de maintenance, et qui ont été enregistrées pour servir ensuite de caractéristiques individuelles de consommation de référence pour ce groupe électrogène.

**13.** Dispositif de surveillance (20) d'un ensemble de production (10) d'électricité,

- l'ensemble de production (10) comportant plusieurs groupes électrogènes ($G_1$, $G_i$, $G_n$) étant alimentés en carburant par une même source de carburant (1) munie d'un moyen de mesure (2) qui délivre une mesure d'un débit total de carburant ($D_{mes,k}$) consommé par l'ensemble des groupes électrogènes dudit ensemble de production (10), chaque groupe électrogène étant muni d'un capteur (C) qui délivre une mesure d'un taux de charge ($LR_{mes,i,k}$) du groupe électrogène considéré ($G_i$),
- le dispositif de surveillance (20) comprenant au moins un module d'acquisition (21), une mémoire (22) et un module de calcul (23) comprenant un processeur, le dispositif de surveillance (20) étant programmé pour déterminer des caractéristiques individuelles de consommation en carburant des différents groupes électrogènes ($G_1$, $G_i$, $G_n$) de l'ensemble de production (10), les caractéristiques individuelles de consommation ($SFC_{i,1}$, $SFC_{i,j}$, $SFC_{i,m}$), associées à chaque groupe électrogène étant représentatives de la consommation spécifique en carburant du groupe électrogène ($G_i$) considéré, pour différents taux de charge ($LR_1$, $LR_j$, $LR_m$) du groupe électrogène,
- le dispositif de surveillance (20) étant programmé pour déterminer lesdites caractéristiques individuelles en exécutant les étapes suivantes :

a) acquérir, au moyen du module d'acquisition (21), des données d'exploitation qui, pour différents instants d'acquisition ($t_k$) répartis au cours d'une période d'acquisition donnée, regroupent :

- la mesure du débit total de carburant ($D_{mes,k}$) consommé, à l'instant d'acquisition ($t_k$) considéré, et
- pour chaque groupe électrogène dudit ensemble de production, la mesure du taux de charge ($LR_{mes,i,k}$) du groupe électrogène ($G_i$) considéré, à l'instant d'acquisition ($t_k$) considéré, et enregistrer les données d'exploitation acquises dans ladite mémoire (22), et

b) déterminer, au moyen du module de calcul, les caractéristiques individuelles de consommation ($SFC_{1,1}$, $SFC_{i,j}$, $SFC_{i,m}$, $SFC_{i,j}$, $SFC_{i,j}$, $SFC_{i,j}$) des différents groupes électrogènes ($G_1$, $G_i$, $G_n$) dudit ensemble de production, par une procédure de minimisation d'un écart cumulé (Obj) qui tient compte d'un ensemble d'écarts instantanés ($EC_k$) associés respectivement aux différents instants d'acquisition ($t_k$), chaque écart instantané ($EC_k$) étant un écart, pour l'instant d'acquisition ($t_k$) considéré, entre :

- d'une part, la mesure du débit total de carburant ($D_{mes,k}$), et
- d'autre part, une estimation du débit total de carburant ($D_{sim,k}$) consommé par ledit ensemble de production d'électricité, ladite estimation du débit total ($D_{sim,k}$) étant égale à la somme de débits individuels estimés ($d_{sim,i,k}$), associés respectivement aux différents groupes électrogènes ($G_i$) de l'ensemble de production (10) d'électricité, chaque débit individuel estimé ($d_{sim,i,k}$) étant déterminé sur la base :
- de la mesure du taux de charge ($LR_{mes,i,k}$) du groupe électrogène ($G_i$) considéré, à l'instant d'acquisition ($t_k$) considéré, et
- des caractéristiques individuelles de consommation ($SFC_{i,1}$, $SFC_{i,j}$, $SFC_{i,m}$) en carburant du groupe électrogène ($G_i$) considéré,
ladite période d'acquisition comprenant plusieurs périodes d'exploitations distinctes, une puissance électrique totale ($P_{tot}$) produite par l'ensemble de production (10) étant répartie de manières différentes entre les groupes électrogènes ($G_1$, $G_i$, $G_n$) de l'ensemble de production au cours des différentes périodes d'exploitation.

# Fig. 1

# Fig. 2

# Fig. 3

# Fig. 4

Europäisches
Patentamt

European
Patent Office

Office européen
des brevets

# RAPPORT DE RECHERCHE EUROPEENNE

Numéro de la demande

EP 20 21 3001

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 106 451 570 B (CSSC SYSTEMS ENG RES INST) 21 août 2018 (2018-08-21) * alinéa [0060] - alinéa [0078] * | 1,4-10, 13 | INV. H02J3/38 H02J3/46 F02D29/06 |
| A | | 2,3,11, 12 | |
| A | EP 3 012 939 A1 (KOHLER CO [US]) 27 avril 2016 (2016-04-27) * le document en entier * | 1-13 | |
| A | US 2017/051692 A1 (ZHANG YANCHAI [US] ET AL) 23 février 2017 (2017-02-23) * le document en entier * | 1-13 | |

DOMAINES TECHNIQUES
RECHERCHES (IPC)

H02J
F02D

Le présent rapport a été établi pour toutes les revendications

| Lieu de la recherche | Date d'achèvement de la recherche | Examinateur |
|---|---|---|
| Munich | 21 décembre 2020 | Martin, Raynald |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 21 3001

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-12-2020

| Document brevet cité au rapport de recherche | | Date de publication | Membre(s) de la famille de brevet(s) | | Date de publication |
|---|---|---|---|---|---|
| CN 106451570 | B | 21-08-2018 | AUCUN | | |
| EP 3012939 | A1 | 27-04-2016 | CN | 104977862 A | 14-10-2015 |
| | | | EP | 3012939 A1 | 27-04-2016 |
| US 2017051692 | A1 | 23-02-2017 | CN | 108290626 A | 17-07-2018 |
| | | | DE | 112016003239 T5 | 09-05-2018 |
| | | | JP | 2018533334 A | 08-11-2018 |
| | | | KR | 20180031767 A | 28-03-2018 |
| | | | US | 2017051692 A1 | 23-02-2017 |
| | | | WO | 2017030711 A1 | 23-02-2017 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- EP 19207140 A